(19) **Europäisches Patentamt / European Patent Office / Office européen des brevets**

(11) **EP 4 546 410 A1**

(12) **EUROPEAN PATENT APPLICATION**
published in accordance with Art. 153(4) EPC

(43) Date of publication:
**30.04.2025 Bulletin 2025/18**

(21) Application number: **23857029.5**

(22) Date of filing: **14.07.2023**

(51) International Patent Classification (IPC):
**H01L 23/373** (2006.01)    **C04B 35/577** (2006.01)
**C22C 29/06** (2006.01)    **H01L 23/36** (2006.01)

(52) Cooperative Patent Classification (CPC):
**C04B 35/565; C22C 29/06; H01L 23/36; H01L 23/373**

(86) International application number:
**PCT/JP2023/026041**

(87) International publication number:
**WO 2024/042913 (29.02.2024 Gazette 2024/09)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **24.08.2022 JP 2022133332**

(71) Applicant: **A.L.M.T. Corp.**
**Tokyo 104-0061 (JP)**

(72) Inventor: **KOYAMA, Shigeki**
**Toyama-shi, Toyama 931-8543 (JP)**

(74) Representative: **Prüfer & Partner mbB**
**Patentanwälte · Rechtsanwälte**
**Sohnckestraße 12**
**81479 München (DE)**

(54) **COMPOSITE MATERIAL, HEAT DISSIPATION SUBSTRATE, AND SEMICONDUCTOR DEVICE**

(57) A composite material includes a heat-dissipating substrate of plate shape including a composite material including a metal and a silicon carbide. A one-side surface of the heat-dissipating substrate is divided into a plurality of regions in a lattice, a length (B1) of a vertical side and a length (L1) of a horizontal side of each of the plurality of regions are 10 mm or more and 25 mm or less, the plurality of regions (2) in the lattice occupy 70% or more of an overall area of the one-side surface of the heat-dissipating substrate (1), and a thermal conductivity is 140 W/(m·K) or more at respective points of the plurality of regions in the lattice. A coefficient of variation of a thermal conductivity is less than 3.0% in the plurality of regions in the lattice. The coefficient of variation is expressed as standard deviation/average value × 100 (%).

FIG.1

EP 4 546 410 A1

# EP 4 546 410 A1

**Description**

TECHNICAL FIELD

The present disclosure relates to a magnesium-based composite material in which magnesium or magnesium alloy is composited with silicon carbide, a heat-dissipating substrate made of the composite material, and a semiconductor device including the heat-dissipating substrate. The present application claims priority based on Japanese Patent Application No. 2022-133332 filed on August 24, 2022. The entire contents of this Japanese patent application are incorporated herein by reference.

BACKGROUND ART

Conventional composite materials are disclosed in, for example, Japanese Patent Laying-Open No. 2006-299304 (PTL 1), Japanese Patent Laying-Open No. 2010-090436 (PTL 2), Japanese Patent Laying-Open No. 2010-106362 (PTL 3), WO 2018/105297 (PTL 4), Japanese Patent Laying-Open No. 2011-073055 (PTL 5), Japanese Patent Laying-Open No. 2016-007634 (PTL 6), and Japanese Patent Laying-Open No. 2011-73950 (PTL 7).

CITATION LIST

PATENT LITERATURE

PTL 1: Japanese Patent Laying-Open No. 2006-299304
PTL 2: Japanese Patent Laying-Open No. 2010-090436
PTL 3: Japanese Patent Laying-Open No. 2010-106362
PTL 4: WO 2018/105297
PTL 5: Japanese Patent Laying-Open No. 2011-073055
PTL 6: Japanese Patent Laying-Open No. 2016-007634
PTL 7: Japanese Patent Laying-Open No. 2011-073950

NON PATENT LITERATURE

NPL 1: Megumi Akoshima from National Institute of Advanced Industrial Science and Technology, "Nestudendouritu, netsukakusanritu no seigyo to sokuteihyoukahouhou [Control, and Measurement and Evaluation Methods for Thermal Conductivity and Thermal Diffusivity], Chapter 3, Section 1, Netsudendouritu, netsukakusanritsu no hyoujun nitsuite [As to Standards of Thermal Conductivity and Thermal Diffusivity] published by Science & Technology Co., Ltd. (in Japanese).

SUMMARY OF INVENTION

A composite material of the present disclosure includes a heat-dissipating substrate of plate shape including a composite material including magnesium or magnesium alloy and silicon carbide. A one-side surface of the heat-dissipating substrate is divided into a plurality of regions in a lattice, vertical and horizontal sides of each of the plurality of regions have a length of 10 mm or more and 25 mm or less, the plurality of regions in the lattice occupy 70% or more of an overall area of the one-side surface of the heat-dissipating substrate, and a thermal conductivity is 140 W/(m·K) or more at respective points of the plurality of regions in the lattice. A coefficient of variation of a thermal conductivity is less than 3.0% in the plurality of regions in the lattice. The coefficient of variation is expressed as standard deviation/average value $\times$ 100 (%).

BRIEF DESCRIPTION OF DRAWINGS

Fig. 1 shows a heat-dissipating substrate 1, a plurality of lattice-shaped regions 2, which are measurement sites thereof, and a sample 4 cut out from a region surrounded by four intersection points 3.
Fig. 2 is a plan view of heat-dissipating substrate 1 with samples Nos. 8 and 9 and semiconductor elements 11 to 16 bonded thereto.

Fig. 3 is a sectional view of a semiconductor device 10 including heat-dissipating substrate 1 taken along the arrow line III-III in Fig. 2.

DESCRIPTION OF EMBODIMENTS

[Problem to be Solved by the Present Disclosure]

A conventional composite material has a problem of large scattering of thermal conductivity.

[Description of Embodiments the Present Disclosure]

First, embodiments of the present disclosure will be listed and described.

(1) Scattering of Characteristics of Heat-Dissipating Substrate

When test pieces are cut out by extracting a plurality of portions from portions of a heat-dissipating substrate that is a composite material (generally, a rectangular flat plate mainly having a thickness of 4 to 5 mm), and thermal conductivities are measured, scattering of thermal conductivity is present.

A heat-dissipating substrate used in a semiconductor device is used for the purpose of efficiently transferring and conveying the heat generated from a semiconductor element. Thermal conductivity [unit: W/(m·K)], which is an index of heat transfer, is used as the numerical value to determine the performance of the heat-dissipating substrate. For materials of the same composition, the same volume, and the same mass, a material having a greater thermal conductivity value transfers heat more easily. The thermal conductivity of the heat-dissipating substrate is measured from a small test piece cut out from the heat-dissipating substrate.

When the thermal conductivity of a plate-shaped heat-dissipating substrate is measured, a measurement piece cut out from an arbitrarily determined portion, such as a representative middle portion or a representative peripheral portion, may be measured to obtain a representative value of the thermal conductivity. Alternatively, sample pieces may be cut out from a predetermined number of portions and measured, and then, an average value thereof may be used as the representative value. For example, the thermal conductivity of an individual heat-dissipating substrate can be expressed as a representative value that is an average value of the values obtained from a total of about two to six test pieces including a test piece cut out from the middle region and several test pieces cut out from the peripheral portion.

However, even if a conventional composite material made of metal and ceramic and a heat-dissipating substrate including the composite material have a uniform composition, such as a volume ratio between composited metal and silicon carbide or a porosity, or have uniform mechanical characteristics such as a strength and an elastic modulus in an individual heat dissipating-substrate, there is a problem of large scattering of characteristics, such as variations and distribution, within the plate when the thermal conductivities extracted and measured from many points are statistically compared with each other.

The heat-dissipating substrates having such characteristic scattering of thermal conductivity and having a large scattering ratio are problematic when being used for a semiconductor device.

The thermal conductivity is expressed as in Equation 1.

$$\lambda = \alpha \cdot Cp \cdot \rho \qquad \text{Equation 1}$$

$\lambda$: thermal conductivity [W/(m·K)]
$\alpha$: thermal diffusivity ($m^2$/s)
$Cp$: specific heat capacity [J/(kg·K)]
$\rho$: bulk density of sample (kg/$m^3$)

Herein, the value obtained by multiplying specific heat capacity by density in a solid corresponds to "A; heat capacity per unit volume (volumetric specific heat)" and is shown as in Equation 2.

$$A = Cp \cdot \rho \ [J/(m^3 \cdot K)] \quad \text{Equation 2}$$

For composite materials with constant conditions of the overall composition and the combination ratio, the value of A is almost constant and is expressed as follows.

EP 4 546 410 A1

$$\lambda = \alpha \cdot A \qquad \text{Equation 3}$$

Thus, from Equation 3, the thermal conductivity can be regarded as a value obtained by multiplying a thermal diffusivity by a constant, and scattering of thermal conductivity is due to scattering of thermal diffusivity.

The inventor has conducted experiment and investigation on the region of the heat-dissipating substrate for thermal diffusion measurement in a wide area range. The inventor has then found that scattering of thermal conductivity of the heat-dissipating substrate is caused by scattering of thermal diffusivity, found a method of suppressing such scattering from the manufacturing method, and discovered a heat-dissipating substrate made of a composite material having good heat dissipation properties.

A large number of measurement points were extracted from a large area, and the coefficient of variation obtained from a standard deviation and an average value was used as an index to compare the degrees of scattering of all the values, and the numerical values were rendered dimensionless and statistically analyzed.

This is because the degree of scattering cannot be correctly compared in comparison between products with widely different thermal conductivities of materials if the range indicating the difference between maximum value and minimum value or the difference between measured value and average value is used for verification.

The coefficient of variation is expressed as standard deviation/average value $\times$ 100 (%).

The coefficient of variation of volumetric specific heat A obtained by multiplying density $\rho$ by specific heat capacity Cp is sufficiently small compared to thermal diffusivity $\alpha$, which indicates that scattering of density $\rho$ and specific heat capacity Cp is small, i.e., the variations are small.

In dense composite materials with a porosity of less than 3% by volume, small scattering of density is a necessary and sufficient factor for a heat dissipating member having a stable shape in PTL 4. In other words, a composite material that is dense and has a uniform structure and a uniform density can provide a heat-dissipating substrate having a stable shape.

(2) Method of Manufacturing Metal-Ceramic Composite Material

Heat-dissipating substrates for semiconductor devices referred to as power modules are made of a composite material of metal and ceramic. An example of the composite material is a composite material of a metal such as pure aluminum, aluminum alloy, pure magnesium, magnesium alloy, copper, or copper alloy, and a silicon carbide. For this "metal-ceramic composite material," a so-called "infiltration method" is selected in which a metal melted by heating to a temperature of the melting point or higher is incorporated into a group of ceramic particles, followed by solidification and molding. This method is also referred to as a metal melting method or an impregnation method.

The infiltration method is selected from among the methods such as pressureless infiltration represented by gravity casting or spontaneous infiltration, pressure infiltration represented by die casting, low-pressure casting, and liquid metal forging. These infiltration methods generally have the following characteristics.

(2-1) Infiltration Process

Since this method involves the penetration of a high-temperature molten metal into pores of a group of ceramic, it is impossible for the entire ceramic to be immersed in the metal instantaneously (or at high speed), and there are entrance portions where a molten metal enters preferentially. Thus, a so-called molten metal flow is an inevitable manufacturing condition in which the molten metal penetrates and migrates through the inside of the group and spreads throughout the group.

(2-2) Internal Behavior in Infiltration Process

When non-metallic ceramic is impregnated with a molten metal, "impurities" on the surface of the ceramic are incorporated into the molten metal.

These impurities are those (including oxide films, for example) present on the surface of the ceramic. Alternatively, impurities may be intentionally placed in advance to form an alloy layer of the impurities and molten metal. For example, impurities are heated in the air to form an oxide film as impurities. Alternatively, impurities may be intentionally added as an infiltration agent (infiltration aid) for the purpose of improving the contact wettability between molten metal and non-metal.

These impurities are incorporated and solid-dissolved when they come into contact with the molten metal, and those that exist even after the molten metal has cooled and solidified as a solid are not selected.

When the molten metal penetrates, some reaction gas may be generated, and if the gas remains and solidifies, defects (blowholes) are caused. These defects do not always occur entirely, but may be occur locally due to a flow of hot water.

Pressure infiltration can suppress defective portions by pressurization even when the wettability between metal and ceramic is poor.

(2-3) Solidification Process

During the process in which the molten metal solidifies, a localized void, so-called shrinkage cavity, is likely to occur due to volume shrinkage of the metal. In particular, since there is a time lag in the manner in which the metal cools and solidifies, a shrinkage cavity occurs at the last solidification point where the metal cools and solidifies.

Generally, when the molten metal melted in a container solidifies, it cools and hardens from the periphery and cools last at the middle portion with the highest temperature. Thus, a shrinkage cavity is usually likely to occur at the middle portion of the container.

In order to suppress this phenomenon, the temperature is made directional during solidification such that shrinkage cavities do not remain inside the product.

For example, a temperature difference is provided such that solidification progresses preferentially on one of the surfaces of the container, either above or below or around the container. For example, the container is exposed to a low-temperature atmosphere or is brought into contact with a low-temperature object such that it will solidify preferentially. Alternatively, for example, the portion where cooling is delayed may be kept warm.

However, if such cooling is performed too quickly, gas entrainment due to solidification contraction may occur, and thus, it is essential to control a cooling rate.

A technique is also used to reduce the blowholes caused by the generated gas, described in the previous section, using this cooling directionality.

Further, impurities incorporated into the molten metal during solidification may be precipitated during the solidification process.

The precipitate does not occur uniformly throughout the product, but is generated non-uniformly depending on conditions such as a temperature during solidification.

(3) Main Cause of Characteristic Scattering by Manufacturing Method

As described above, in compositing of metal with ceramic in the infiltration method, there is a linear flow in migration and solidification of the molten metal, which causes scattering of thermal conductivity. In particular, there are local component separation when impurities are solid-dissolved in the molten metal, non-uniform precipitation of a crystallite during solidification of the molten metal and impurities, and distribution of minute defects or internal structure that cannot be discerned with a microscope, such as those present in gaps between metal and ceramic after solidification. These are the factors that cause scattering of thermal diffusivity.

Minute defects mean voids so small that they do not affect density, which cannot be discerned by nondestructive testing such as ultrasonography or X-ray transmission testing. It is needless to say that defects large enough to be discerned as obvious defects by these inspections not only reduce the thermal conductivity but also reduce other characteristics such as strength, and a substrate having such defects is not suitable as a heat-dissipating substrate.

Non-metallic ceramic particles do not react with a metal to destroy or damage particles.

Composite materials produced by the infiltration method are found to yield non-uniform contact between metal and non-metal, causing scattering of thermal diffusivity.

(4) Reference Comparison of Any Other Manufacturing Method

As a comparison, a composite material (e.g., sintered Al-SiC available from A.L.M.T. Corp.) produced by a so-called sintering method, in which powder is sintered for production, is produced by pressing a raw powder in the direction of a large area of plate shape and then sintering the raw powder at a temperature lower than the melting temperature of the metal, which less easily causes variations. However, in order to obtain a higher thermal conductivity, products of large area, e.g., an area of 50 cm$^2$ or more, require a high-pressure forming apparatus and are not suitable for industrial mass production.

In a power module in which a semiconductor that operates at high temperatures is mounted, large scattering of characteristics such as distribution and variations of thermal conductivity results in a resistance to a heat flow from the semiconductor.

(5) Effects of the Present Disclosure

Since circuits including a plurality of semiconductor elements are usually mounted side by side in a power module, a local decrease in thermal conductivity leads to poor heat evacuation and shortens the life of the semiconductor.

In PTL 4, a shape is stabilized to suppress a decrease in thermal resistance.

Power modules used in vehicles, industrial devices, power generation, railroads, communication equipment, and the like include semiconductor elements (also referred to as semiconductor devices) mounted therein, such as insulated gate bipolar transistors (IGBTs) and metal oxide semiconductor field effect transistors (MOSFETs), and are used for power conversion and device control to control current and voltage.

The inside of the power module has a structure in which circuit boards including a plurality of semiconductor elements are mounted side by side, and the semiconductor elements turn on and off electric power repeatedly at high speed, thus generating heat corresponding to the resistance component in the circuit. The heat-dissipating substrate is required to efficiently transfer and convey the heat generated by the semiconductor elements and to withstand thermal deformations so as not to be deformed by the thermal history during assembly of the power module or by thermal cycling during use.

In recent years, the performance to dissipate the heat generated from semiconductor elements, which is so-called higher heat dissipation performance, has been demanded due to higher voltage, larger current, and smaller size.

In thermal design of power modules, a flow of heat from high temperature to low temperature is verified by simulating a thermal resistance using the thermal conductivities of semiconductors and other components, and then calculating structural functions through actual measurements. If scattering of thermal conductivity within a plate results in large variations or a large decrease in some portions, the thermal design is forced to assume such variations or such portions, and a safety factor must be designed high.

Power modules are designed to operate at temperatures below a set junction temperature of a semiconductor element. If the element exceeds the junction temperature, a thermal runaway occurs in which a higher current flows to cause a temperature rise, destroying the device.

As the temperature rises, the temperature change causes phenomena such as delamination of a junction, degradation in insulation performance, and fatigue breakdown of a material, which may lead to shorter life. Therefore, power modules need thermal management design that allows more efficient heat dissipation.

The performance required for heat-dissipating substrates naturally favors materials with higher thermal conductivity. Further, materials with reduced thermal resistance are also required.

A heat-dissipating member of the present disclosure, which has small scattering of characteristics such as distribution and variations of thermal conductivity, enables thermal management design with reduced thermal resistance.

In a power module, a plurality of semiconductor elements, which are heat-generating elements, are joined together by soldering and are arranged on a heat-dissipating substrate.

At that time, mutual interference of heat among semiconductor elements in close proximity may occur to cause an overall temperature to become higher than when a single semiconductor element is used. This is referred to as thermal interference.

When semiconductor elements are placed in close proximity to portions with large scattering of thermal conductivity within a heat-dissipating substrate, a thermal resistance increases further and thermal interference occurs, which is likely to cause a temperature rise.

Such a thermal resistance is lower in a plate with smaller scattering of thermal conductivity than in a conventional plate with large scattering of thermal conductivity.

For example, in comparison of a sample (a) with an average of 170 W/(m·K) and a sample (b) with an average of 210 W/(m·K), if both the samples have scattering in the same wide variation range, a difference is unlikely to occur in thermal resistance between sample (a) and sample (b). However, if scattering is suppressed by reducing the variation range of thermal conductivity of both the samples, sample (b) with an average of 210 W/(m·K) has a smaller thermal resistance, and sample (b) has better heat dissipation than sample (a).

The measurement of thermal conductivity of a heat-dissipating substrate made of a composite material is a so-called destructive test in which a sample piece, which will be described later, is cut out and measured.

Therefore, in use of a heat-dissipating substrate with large characteristic scattering of thermal conductivity, the designer of semiconductor devices such as power devices needs to design in advance with a margin for heat dissipation characteristics from a heating element in order to avoid such scattering.

Alternatively, the designer has no choice but to design while taking into account a high safety factor, for example, an increased proximity spacing between heat-generating semiconductors.

In the case of a heat-dissipating substrate with small characteristic scattering of thermal conductivity, heat generation due to mutual interference can be suppressed, and close proximity layout design can be easily made, thus ensuring reliability.

Further, when assuming the use of a material with a higher thermal conductivity, a heat-dissipating substrate with small characteristic scattering results in noticeable effects on a reduction in thermal resistance.

This can be explained for the same reason as the aforementioned comparison of plates between sample (a) with an average of 170 W/(m·K) and sample (b) with an average of 210 W/(m·K). Thermal resistance is defined as follows.

Thermal resistance Rth = Thickness L/(cross-sectional area × thermal conductivity), where L is a spacing in which heat flows.

(6) As to Measurement of Thermal Conductivity

For materials with a high thermal conductivity, thermal conductivity is measured by laser flash (LF) among the various existing measurement methods.

The thermal conductivity of the composite material of the present disclosure was measured by the following method and calculated from Equation 1 or Equation 3.

Thermal diffusivity $\alpha$ was measured by laser flash (LF). The measurement conforms to JIS R 1611 (2010) and ASTM E 1461.

For specific heat capacity Cp, a value measured by differential scanning calorimetry (DSC) was used.

For bulk density $\rho$, the bulk density of a sample was obtained by dividing the mass of the sample by an external volume.

Thus, thermal conductivity $\lambda$ was derived.

For the principle of measuring thermal diffusivity $\alpha$ by laser flash (LF), a so-called unsteady-state method is used in which a sample cut out into a fixed area is heated by application of pulsed light, and a thermal change is measured for calculation.

In contrast, the steady-state method is a method of performing measurement by application of a heat flux, and is not suitable for materials with high thermal conductivity, such as heat-dissipating materials used in semiconductor devices.

Specific heat capacity Cp can be measured by differential calorimetry or adiabatic calorimetry in addition to the DSC. Alternatively, the values described in the literatures may be used.

For density $\rho$, a bulk density derived from mass and external volume is applied. Alternatively, density $\rho$ can be measured using an apparent density by the Archimedes method, which uses underwater weighing.

This is because a measurement error in these measurements does not affect scattering of characteristics in composite materials with a porosity of less than 3% by volume in the present disclosure.

Measurements were performed on measurement pieces cut out into 10 mm in diameter and 1 to 5 mm in thickness.

Thermal diffusivity was measured using LFA447 available from NETSZH Group.

Specific heat capacity was measured using DSC3500 available from NETSZH Group.

(6-2) Measurement Method with Suppressed Measurement Error

In the measurement of thermal diffusivity by laser flash, the surface of a flat-shaped sample is instantaneously heated by spatially uniform pulsed light, and a temperature rise on the rear surface of the sample is observed.

The measurement error of laser flash is mainly due to the error of the surface temperature during measurement, and is caused by the surface condition (roughness), thickness, and parallelism of a test piece, so the measurement and comparison are performed using test pieces having the unified surface condition (roughness), thickness, and parallelism.

Generally, an average value is taken through a plurality of measurements, but in order to eliminate measurement error factors, the average value of three or more measurements on the same sample is used, and if the difference between the maximum and minimum values is more than or equal to 8% of the average value (more than or equal to the range of $\pm$4% of the average value), the measured value is not used. In such a case, the sample error (surface condition, thickness, parallelism) and factors such as changes or deterioration of a measuring instrument are eliminated, corrected, or calibrated, and then the value measured again in the same manner is adopted.

(7) Improvement by the Present Disclosure

During infiltration and solidification, the affinity (or wettability) between ceramic particles and molten metal was improved, and the solid solution segregation of impurities into the molten metal was stabilized, leading to improvements by the present disclosure.

(8) Product Structure

(8-1) As to Metals

A pure magnesium and a magnesium alloy are applicable.

For the pure metal, a low content of impurities is more preferable, and the magnesium content is preferably 99.5% by mass or more, and more preferably, 99.9% by mass or more.

The magnesium alloy contains an element added for imparting thereto corrosion resistance, strength, and safety against combustion. Examples of the added element include one or more elements selected from Al, Si, Ca, Zn, Li, Cu, Ti, Y, and Zr.

(8-2) As to Ceramic

Silicon carbide is applicable.

For the purity of silicon carbide, a silicon carbide component is preferably 95% by mass or more, and more preferably, 99% by mass or more.

Silicon carbide powders are sieved and classified with a standard scale aperture based on JIS Z8801, and the particle size range is preferably from 1 to 330 μm.

More preferably, the particle size is in the range of 5 to 150 μm.

This is the minimum particle range that is easy to handle while taking into consideration powder dispersion that may be detrimental to environmental or health, and is also the maximum particle range that is easy to process while taking into consideration factors such as machining resistance or degranulation in subsequent cutting or polishing.

In particular, minute particles or ultrafine powders smaller than 1 μm are difficult to handle.

Wire-cut electric discharge machines, described later, generally use electrode wires with a wire diameter of 0.2 to 0.3 mm. Thus, if the particle diameter is extremely larger than the wire diameter, a cutting resistance is caused, and accordingly, cutting cannot be performed.

The particle size of the silicon carbide is not a problem for the heat-dissipating substrate of the present disclosure, which has small characteristic scattering of thermal conductivity, and does not need to be specified.

The factor that determines an average value of thermal conductivity of the entire heat-dissipating substrate depends on the volume fractions of metal and silicon carbide.

In other words, the metal enters the gap between particles of a group of silicon carbide powder, and thus, a plate with a desired thermal conductivity can be obtained by determining the void fraction of the group of silicon carbide.

In other words, in order to determine the void fraction of a group, it is not always necessary to use a powder of a single particle size, but it is sufficient to use a silicon carbide powder with a particle size distribution or to mix together silicon carbide powders with a plurality of particle size distributions.

For example, if two or more non-metallic powders with different average particle sizes are mixed together, the void fraction will become smaller, and a plate with a higher thermal conductivity can be made.

However, a good industrial quality can be maintained by setting these particle size distributions within the range obtained by sieving with a standard sieve conforming to JIS Z8801, and manufacturing and controlling a plate using a powder having a particle size distribution based on the average particle diameter.

(9) Example of How to Produce Magnesium-Silicon Carbide Composite Material of the Present Disclosure

(9-1) Step of Preparing Silicon Carbide

A silicon carbide powder that is a raw material is a silicon carbide as described in item (8-2) "As to Ceramic". This silicon carbide powder is subjected to plasma treatment.

Plasma is broadly classified into high-temperature plasma (also called thermal plasma) and low-temperature plasma. High-temperature plasma is in the state of ionized gas having a high temperature of several thousand degrees Celsius or higher. The plasma treatment of the present disclosure uses low-temperature plasma. In this plasma treatment, the gas converted into plasma can be used to modify the material surface or remove organic matter or the like. The affinity (or referred to as wettability) between silicon carbide particles and a molten metal such as magnesium is improved, and solid solution segregation of impurities into the molten metal is suppressed.

Plasma treatment is generally performed by the method using fluorine, hydrogen, nitrogen, helium, or the like, in addition to oxygen. Although any of these methods can be applied to the present disclosure, oxygen plasma is most effective for silicon carbide particles.

For the treatment method, vacuum plasma or atmospheric-pressure plasma is applied.

In the vacuum plasma method, a small amount of radicalized gas is injected under vacuum for treatment.

The same effects can be obtained with atmospheric-pressure plasma, in which radicalized gas is applied in an environment where the pressure is not reduced.

The difference between the methods is that vacuum plasma is difficult to be formed in a line due to a restriction on the capacity to maintain a vacuum. Atmospheric-pressure plasma has no such a restriction, but requires an exhaust facility for generated ozone. The same effects can be obtained though there is such a difference.

In plasma treatment, a raw powder is placed in a container that is made of glass, ceramic, metal, or the like and that can withstand temperatures of up to approximately a hundred and several tens of degrees Celsius, with no particular restrictions on the shape or size of the container.

Plasma treatment is performed by placing a to-be-treated object in a plasma treatment apparatus, reducing the pressure, feeding a small amount of oxygen gas under a reduced pressure of 100 Pa or less, and applying high-frequency power.

Plasma treatment can be performed in a commercially-available plasma treatment apparatus. The apparatus used in the present disclosure is the plasma reactor apparatus available from Yamato Scientific Co., Ltd.

With the chamber of the apparatus being depressurized by a vacuum pump, 50 to 100 cm$^3$ of oxygen is supplied per minute from an oxygen gas cylinder. A voltage is applied to an electrode with an output of 200 W, and the treatment can be performed for 10 minutes.

(9-2) Adjustment of Impurities

Products, powders, binders, and the like in the following methods can be dispersed as "impurities" uniformly in the group of non-metals after plasma treatment. The impurities need not to be present.

In an example method, an oxide is produced on the surface of the silicon carbide powder. In this method, the silicon carbide powder is heated at 700 to 1100°C in the air.

In another method, a powdered oxide is mixed with a non-metallic powder. The examples of the oxide include an aluminum oxide and a silicon oxide.

In another method, the silicon carbide powder is mixed with a binder to produce a molded body (also referred to as a preform) in advance. Alternatively, the method involving a combination of these methods may be adopted.

The impurities may be an oxide film present in the silicon carbide powder or an oxide that is intentionally added as an infiltration aid for the purpose of improving wettability.

(9-3) Step of Preliminarily Placing Non-Metallic Powder or Molded Body of Solidified Non-Metallic Powder in Die

To place the silicon carbide powder in a die, in one method, the silicon carbide powder is fed into, and then put into, the die by applying mechanical energy to the powder, such as vibrations by shock waves or sine waves, or by impact such as tapping using a drop. In another method, the powder is fed into the mold and then pressed. Any of these methods can be selected.

The method of solidifying the powder in a molded body can also be selected from among pressure molding, slurry casting, slip casting, doctor blading, and the like.

In the method of solidifying the molded body, the silicon carbide powder is molded with a binder and is solidified, and then, if necessary, a resultant body is heated and sintered so as to hold its shape, and is then placed in the die. In an example method, the silicon carbide powder is mixed with a liquid silicon oxide, molded, and then fired at 600°C or higher.

The silicon carbide powder heated and sintered to the recrystallization temperature or higher may be placed in the die. In an example method, a SiC powder is mixed with a liquid silicon oxide, molded, and then fired at 2000°C or higher.

(9-4) Step of Compositing Metal with Non-Metal

A metal is heated to its melting point or higher and infiltrated into the silicon carbide powder to obtain a composite. The production method is selected from among gravity casting, spontaneous infiltration, die casting, low-pressure casting, and liquid metal forging. The metal can be selected from among magnesium alloys such as known AZ (Mg-Al-Zn alloy), AM (Mg-Al-Mn alloy), ZK (Mg-Zn-Zr alloy), and LA (Mg-Li alloy), in addition to pure magnesium.

In impregnation of silicon carbide with a molten metal, impurities present on the silicon carbide surface are incorporated into the molten metal.

For example, an aluminum oxide, a silicon oxide, or any other oxide is incorporated into the molten metal to be solid-dissolved.

(9-5) Solidification Step

Cooling is controlled, and the structure of a precipitate or the like is controlled, thereby suppressing a shrinkage cavity. This is the same as the "Solidification Process" in (2-3) above.

(9-6) Machining Step

A resultant composite material is shaped by cutting, milling, grinding, electrical discharge machining, or the like. The composite material is aligned to the external shape and thickness dimensions. A heat-dissipating substrate is produced by the machining step of drilling holes for fixing, and the step of forming a coating such as plating on the surface.
The thickness of the heat-dissipating substrate is, for example, 3 to 6 mm. Examples of the size (length B $\times$ width L) include 190 mm $\times$ 140 mm, 130 mm $\times$ 140 mm, 100 mm $\times$ 140 mm, and 70 mm $\times$ 140 mm.

(10) Method of Measuring Thermal Conductivity

(10-1) Measurement Region

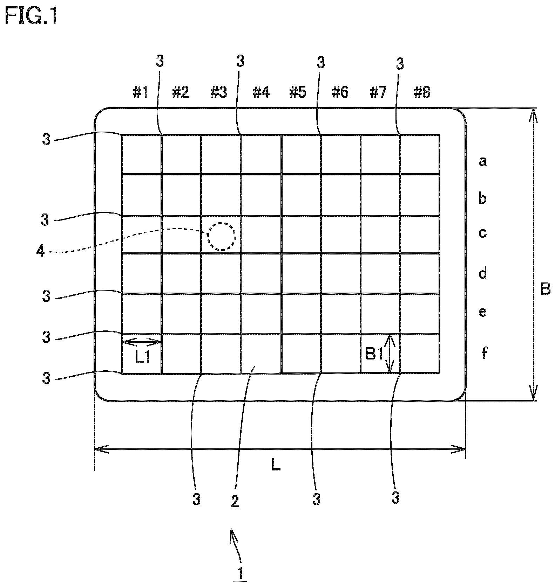

Fig. 1 shows a heat-dissipating substrate 1, a plurality of lattice-shaped regions 2, which are measurement sites thereof, and a sample 4 cut out from a region surrounded by four intersection points 3. The surface of heat-dissipating substrate 1 is allocated to regions 2, each of which has a length of 25 mm or less and a width of 25 mm or less and a length of 10 mm or more and a width of 10 mm or more.
Regions 2 are provided in heat-dissipating substrate 1. Regions 2 are virtual regions on heat-dissipating substrate 1. Sample 4 is produced from the region surrounded by four intersection points 3 in regions 2.
The minimum range of regions 2 is determined in order to cut out sample 4 of $\phi$10 mm. Regions 2 are necessarily larger than $\phi$ 10 mm.
If there is a dissimilar material layer such as a plating around heat-dissipating substrate 1, regions 2 are taken such that sample 4 of $\phi$ 10 mm is not covered with the dissimilar material layer. If part of heat-dissipating substrate 1 has a hole portion for fastening or a portion that obviously has a different shape (e.g., a hole portion for fastening is made of metal alone for a reinforcement purpose), regions 2 should be set avoiding such a portion.
In other words, only the portion of the magnesium-silicon carbide composite material is used as a target measurement portion, and other portions are avoided.

(10-2) Production of Sample 4 for Measurement

Sample 4 for measurement is produced by cutting out a disc shape of $\phi$ 10 mm from a plurality of regions 2 of heat-dissipating substrate 1. As for dimensional accuracy, a tolerance of $\pm$0.10 mm is preferable for sample 4 having an outer diameter of approximately 10 mm in the present disclosure.
Any of the following machining methods is preferred to achieve such an accuracy. After rough cutting, the outer circumference is cut or ground on a lathe to produce sample 4 in a disc shape of $\phi$ 10 mm, or wire-cut electrical discharge machining is used to produce sample 4 in a disc shape of $\phi$ 10 mm.
Laser cutting or water-jet cutting should be avoided due to poor accuracy of dimensions and roundness. Punching with a die should not be used because it easily causes surface droop, burrs, and cracks in sample 4.
The measurement surface (either side of a circular shape of $\phi$ 10 mm) of sample 4 is made as smooth as possible and finished with two parallel flat surfaces.
For example, grinding is performed with a diamond wheel (abrasive grain on the order of #120 to 320).
The roughness of the measurement surface is preferably Ra $\leq$ 15 $\mu$m, and the parallelism is preferably $\pm$0.05 mm.
The thickness of sample 4 is 1 to 5 mm. Samples 4 of $\phi$ 10 mm cut out from a single plate are based on a uniform thickness.
The individual variation range of the thickness of sample 4 of $\phi$ 10 mm is approximately $\pm$0.2 mm or less.
The above machining is usually performed in a wet manner. This is because dry machining generates heat, leading to problem with accuracy and thermal deformation. After machining, sludge on the surface should be removed and moisture should be removed sufficiently by drying. This is because dirt or moisture hinders correct measurement.
As to plate thickness and shape, if both surfaces of heat-dissipating substrate 1 are not flat, for example, if there are curved surfaces such as surfaces of saddle horse shape or cylinder side surfaces, spherical or ellipsoidal surfaces, or slightly irregularly curved surfaces, measurement should be performed with the surfaces made parallel to each other and with the same thickness after cutting from the plate.
If the thickness of heat-dissipating substrate 1 is not uniform, for example, if a plate is shaped into a convex or concave lens, where the thickness is intentionally increased at the middle portion or the peripheral portion of the plate, samples 4 for measurement, which are cut out in the same manner as described above, should be measured with their shape aligned.
If an additional metal layer is formed on the surface of heat-dissipating substrate 1 by plating or thermal spraying, measurement should be performed with the additional layers on both surfaces of the measurement sample removed.

However, any additional metal layer formed on the surface, which has the uniform thickness, interface adhesion, component, and composition throughout the layer, can be compared without removal.

In so doing, it would be much better if the influence of the resistance of the layered interface can be predicted in advance and the measured value of thermal conductivity can be corrected accordingly.

Additional Note 1

A composite material includes a heat-dissipating substrate 1 of plate shape including a composite material including a metal and a silicon carbide. A one-side surface of heat-dissipating substrate 1 is divided into a plurality of regions 2 in a lattice, a length B1 of a vertical side and a length L1 of a horizontal side of each of regions 2 are 10 mm or more and 25 mm or less. Regions 2 in the lattice occupy 70% or more of an overall area of the one-side surface of heat-dissipating substrate 1. A thermal conductivity is 140 W/(m·K) or more at each point of regions 2 in the lattice. A coefficient of variation of a thermal conductivity is less than 3.0% in regions 2 in the lattice. The coefficient of variation is expressed as standard deviation/average value $\times$ 100 (%). If the thermal conductivity is less than 140 W/(m·K), heat cannot be dissipated sufficiently due to a lower thermal conductivity. If the coefficient of variation is 3.0% or more, heat cannot be dissipated sufficiently due to a greater difference in thermal conductivity at each portion.

Additional Note 2

In additional note 1, the metal includes at least one selected from the group consisting of pure magnesium and a magnesium alloy.

Additional Note 3

In additional note 1 or 2, a content of the non-metal is 40% by volume or more and 95% by volume or less, a porosity is less than 3% by volume, and a remainder is a metal. If the content of the non-metal is less than 40% by volume, the non-metal component may be reduced and the coefficient of thermal expansion may become too large. If the content of the non-metal exceeds 95% by volume, the ratio of the non-metal increases and the thermal conductivity decreases. The term "may" indicates that there is a slight possibility that this will be the case, and does not mean that there is a high probability that this will be the case.

Additional Note 4

In any one of additional notes 1 to 3, a coefficient of thermal expansion at temperatures of 25°C to 150 °C is 3.5 to 20 ppm/K. If the coefficient of thermal expansion is outside this range, the difference in coefficient of thermal expansion between the semiconductor elements may increase.

Additional Note 5

A heat-dissipating substrate including the composite material according to any one of additional notes 1 to 4, wherein a coefficient of variation of a volumetric specific heat obtained by multiplying density by specific heat is smaller than the coefficient of variation of the thermal conductivity at respective points of the plurality of regions in the lattice. Since the coefficient of variation of the volumetric specific heat is smaller than the coefficient of variation of thermal conductivity, it is shown that the heat-dissipating substrate of the present disclosure is a composite material with uniform physical characteristics and uniform mechanical characteristics such as strength, hardness, and toughness, and is advantageous in terms of heat deformation resistance. In other words, advantageously, the heat-dissipating substrate achieves both uniform thermal characteristics and shape stability.

Additional Note 6

A semiconductor device of the present disclosure includes the composite material of any one of additional notes 1 to 5.

[Details of Embodiments of the Present Disclosure]

(11) Examples

(11-1) Production of Samples

Samples with Sample Nos. 1 to 7 shown in Table 1 were produced. The manufacturing method was in accordance with "(2) Method of Manufacturing Metal-Ceramic Composite Material".

[Table 1]

| Table 1 | Metal | Silicon Carbide | Powder pretreatment | Impurities | Dimensions mm thickness × length × width | Measurement region and number | | | |
|---|---|---|---|---|---|---|---|---|---|
| Sample No. | Type | Volume ratio % | | | | Lattice region | Lattice arrangement | Number of measurement points | Lattice area ratio |
| 1 | Mg | 71 | not performed | Silicon oxide added | 5 × 140 × 190 | 25 × 25 mm | 5 × 7 lines | 35 | 0.82 |
| 2 | Mg | 71 | not performed | Surface oxidized | 5 × 140 × 100 | 20 × 25 mm | 5 × 5 lines | 25 | 0.89 |
| 3 | Mg alloy | 68 | not performed | Surface oxidized | 5 × 140 × 100 | 20 × 25 mm | 5 × 5 lines | 25 | 0.89 |
| 4 | Mg | 70 | performed | Surface oxidized | 5 × 140 × 100 | 20 × 25 mm | 5 × 5 lines | 25 | 0.89 |
| 5 | Mg | 70 | | Silicon oxide added | 5 × 140 × 190 | 25 × 25 mm | 5 × 7 lines | 35 | 0.82 |
| 6 | Mg | 68 | | Silicon oxide added | 5 × 140 × 130 | 25 × 25 mm | 5 × 5 lines | 25 | 0.86 |
| 7 | Mg alloy | 68 | | Surface oxidized | 5 × 140 × 190 | 25 × 25 mm | 5 × 7 lines | 35 | 0.82 |

Sample Nos. 1 to 7 were classified according to the following criteria.

Metal: Two types including Mg and Mg alloy
Powder pretreatment: performed or not performed
Form of impurities: surface oxidized or silicon oxide added
Plate size: thickness standardized at 5 mm, and other dimensions being 100 mm, 140 mm, and 190 mm with 140 mm as a standard

The measurement points were extracted where 20 to 25 mm was the lattice reference for each size.

The coefficient of linear expansion was in the range of 7 to 8 ppm/K.

The lattice area ratio in Table 1 means the area ratio of lattice-shaped regions 2 to the overall area of the one-side surface of heat-dissipating substrate 1.

(11-2) Measurement of Thermal Conductivity

For Sample Nos 1. 1 to 7, the coefficient of variation was calculated by measuring the thermal conductivity in accordance with "(6) As to Measurement of Thermal Conductivity".

[Table 2]

| Table 2 | Thermal conductivity W/(m·K) | | | | | |
|---|---|---|---|---|---|---|
| Sample No. | Maximum | Minimum | Range | Average | Standard deviation | Coefficient of variation (%) |
| 1 | 229 | 209 | 20 | 215 | 7.03 | 3.27 |
| 2 | 225 | 207 | 18 | 218 | 6.85 | 3.14 |
| 3 | 175 | 155 | 20 | 167 | 5.74 | 3.44 |
| 4 | 228 | 220 | 8 | 224 | 2.28 | 1.02 |
| 5 | 230 | 218 | 12 | 226 | 2.87 | 1.27 |
| 6 | 206 | 193 | 13 | 200 | 4.58 | 2.29 |
| 7 | 172 | 158 | 15 | 165 | 4.64 | 2.81 |

A heat-dissipating substrate produced by the same manufacturing method as that used for Sample No. 1 and Sample No. 5 was used to produce a simulated configuration of a power module, and the heat dissipation from the heat-generating semiconductor to the heat-dissipating substrate was evaluated.

Heat-dissipating substrate with Sample Nos. 8 and 9 were produced as shown in Table 3.

[Table 3]

| Table 3 | Semiconductor element | Cooling time (sec.) | | Semiconductor element | Cooling time (sec.) |
|---|---|---|---|---|---|
| Sample No. 8 (Same manufacture conditions as those of Sample No. 1) | 11 | 89 | Sample No. 9 (Same manufacture conditions as those of Sample No. 5) | 11 | 88 |
| | 12 | 118 | | 12 | 101 |
| | 13 | 106 | | 13 | 92 |
| | 14 | 90 | | 14 | 88 |
| | 15 | 91 | | 15 | 98 |
| | 16 | 90 | | 16 | 94 |

(continued)

| Table 3 | Semiconductor element | Cooling time (sec.) | | Semiconductor element | Cooling time (sec.) |
|---|---|---|---|---|---|
| Maximum | 118 | Maximum | 101 | | |
| Minimum | 89 | Minimum | 88 | | |
| Range (maximum - minimum) | 29 | Range (maximum - minimum) | 13 | | |
| Average | 97 | Average | 94 | | |

Sample No. 8 was produced on the same conditions as those of Sample No. 1. Sample No. 9 was produced on the same conditions as those of Sample No. 5.

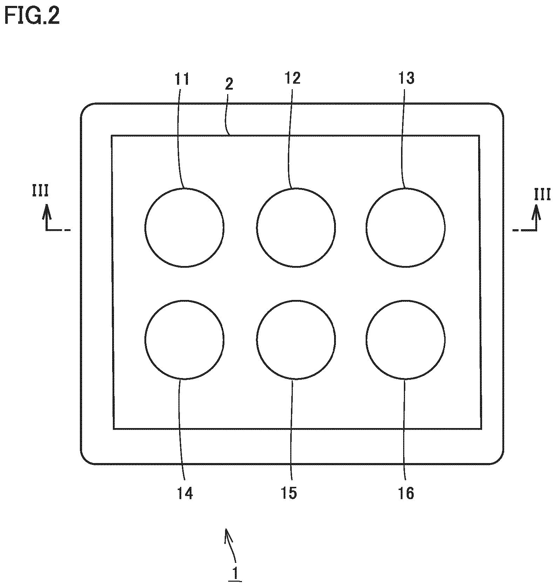

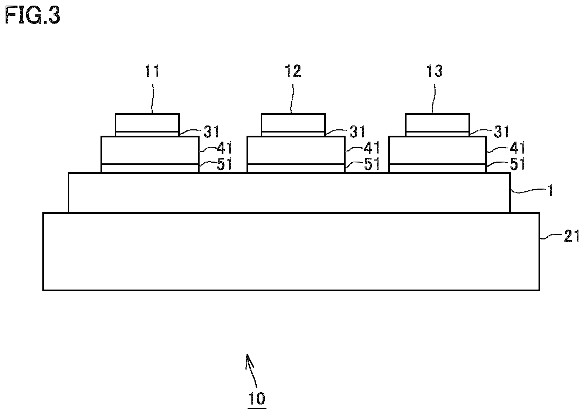

Fig. 2 is a plan view of heat-dissipating substrate 1 with Sample Nos. 8 and 9 and semiconductor elements 11 to 16 bonded thereto. Fig. 3 is a sectional view of a semiconductor device 10 including heat-dissipating substrate 1 taken along the arrow line III-III in Fig. 2.

Sample Nos. 8 and 9 are heat-dissipating substrate 1 formed of metal-silicon carbide composite material with a size of approximately 140 mm × 190 mm × 5 mm (thickness). Semiconductor elements 11 to 16 were simulatively bonded to the one-side surface of heat-dissipating substrate 1, and their behaviors were measured.

An insulating substrate 41 was soldered to six portions on the one-side surface of heat-dissipating substrate 1 with a solder 51. Semiconductor elements 11 to 16 were bonded to insulating substrate 41 with a solder 31.

Insulated gate bipolar (IGBT) chips (transistors) were used as semiconductor elements 11 to 16.

An aluminum nitride was used as insulating substrate 41. Insulating substrate 41 is a direct copper bonding (DCB) substrate because copper circuits are bonded to both surfaces of the aluminum nitride. The size of the aluminum nitride was a thickness of approximately 0.6 mm and $\phi$ 30 mm.

On heat-dissipating substrate 1, a cooler 21 was attached to the side opposite to the surface on which semiconductor elements 11 to 16 are mounted. Cooler 21 was placed by fastening with holes around heat-dissipating substrate 1 such that the entire one-side surface of heat-dissipating substrate 1 was in contact with water-cooled cooler 21 maintained at 30°C.

A current was applied to semiconductor elements 11 to 16, and each of the six portions was controlled to reach approximately 150°C. When these were stabilized and entered a steady state, the application of a current was stopped to stop heat generation, and a time required for the heat from semiconductor elements 11 to 16 to be transferred to heat-dissipating substrate 1 and for the temperature to decrease was measured. At this time, the portion around heat-dissipating substrate 1 was covered with a heat insulating material to eliminate the influence of ambient temperature.

The temperatures of semiconductor elements 11 to 16 are determined by using the relationship between input power and temperature of semiconductor elements 11 to 16, measuring the transition of voltage while passing a weak current with negligible heat generation, and converting it to temperature. Alternatively, the same measurement can be performed with commercially available non-contact temperature measurement or contact temperature measurement.

The times required for semiconductor elements 11 to 16 to cool down from a steady state of 150°C to 80°C were compared, and results of the comparison are shown in Table 3.

Sample Nos. 8 and 9 have the same highest value of thermal conductivity, but Sample No. 8 has a lower lowest value and has an average value lower by approximately 10 W/(m·K).

As a result, it is found that Sample No. 8 has a longer delay and more variations in cooling time. It can be understood that this temperature difference is a difference in thermal resistance.

Twenty-five (5 × 5) regions 2 (matrix) on the surfaces of Sample Nos. 2, 4, 6 were numbered #1 to #5 in the horizontal direction (L-direction) and were numbered a to e in the vertical direction (B direction). The position of each of the 25 regions 2 was identified by the combination of #1 to #5 and a to e. Data at the respective measurement points #1a to #5e for Sample Nos. 2, 4, 6 is shown in Tables 4 to 12 in detail.

[Table 4]

| $\alpha$; thermal diffusivity m$^2$/s at each measurement position of Sample No. 2 | | | | | |
|---|---|---|---|---|---|
| Table 4 | #1 | #2 | #3 | #4 | #5 |
| a | 102 | 108 | 105 | 101 | 102 |
| b | 108 | 101 | 107 | 101 | 109 |

(continued)

| α; thermal diffusivity m²/s at each measurement position of Sample No. 2 | | | | | | | |
|---|---|---|---|---|---|---|---|
| Table 4 | #1 | #2 | #3 | #4 | #5 | | |
| c | 104 | 102 | 109 | 108 | 103 | Average | 105 |
| d | 103 | 107 | 105 | 109 | 108 | Standard deviation | 3.23 |
| e | 109 | 104 | 101 | 101 | 101 | Coefficient of variation % | 3.08 |

[Table 5]

| A; specific heat capacity per unit volume J/(m³·K) at each measurement position of Sample No. 2 Specific heat capacity per unit volume A is expressed by specific heat capacity Cp × bulk density ρ | | | | | | | |
|---|---|---|---|---|---|---|---|
| Table 5 | #1 | #2 | #3 | #4 | #5 | | |
| a | 2.05 | 2.06 | 2.06 | 2.06 | 2.05 | | |
| b | 2.06 | 2.06 | 2.06 | 2.06 | 2.06 | | |
| c | 2.06 | 2.06 | 2.06 | 2.06 | 2.06 | Average | 2.06 |
| d | 2.05 | 2.06 | 2.06 | 2.06 | 2.06 | Standard deviation | 0.00312 |
| e | 2.06 | 2.06 | 2.06 | 2.05 | 2.06 | Coefficient of variation % | 0.15 |

[Table 6]

| λ; thermal conductivity W/(m·K) at each measurement position of Sample No. 2 | | | | | | | |
|---|---|---|---|---|---|---|---|
| Table 6 | #1 | #2 | #3 | #4 | #5 | max | 225 |
| a | 209 | 223 | 216 | 208 | 210 | min | 207 |
| b | 223 | 208 | 221 | 207 | 224 | max-min | 18 |
| c | 213 | 210 | 224 | 223 | 213 | Average | 216 |
| d | 211 | 221 | 216 | 224 | 224 | Standard deviation | 6.76 |
| e | 225 | 215 | 209 | 208 | 208 | Coefficient of variation % | 3.14 |

[Table 7]

| α; thermal diffusivity m²/s at each measurement position of Sample No. 4 | | | | | | | |
|---|---|---|---|---|---|---|---|
| Table 7 | #1 | #2 | #3 | #4 | #5 | | |
| a | 108 | 107 | 107 | 109 | 106 | | |
| b | 107 | 109 | 108 | 107 | 109 | | |
| c | 108 | 108 | 107 | 108 | 107 | Average | 108 |
| d | 107 | 106 | 109 | 106 | 106 | Standard deviation | 1.06 |
| e | 107 | 110 | 107 | 107 | 108 | Coefficient of variation % | 0.99 |

[Table 8]

| A; specific heat capacity per unit volume J/(m³·K) at each measurement position of Sample No. 4 Specific heat capacity per unit volume A is expressed by specific heat capacity Cp × bulk density ρ | | | | | | | |
|---|---|---|---|---|---|---|---|
| Table 8 | #1 | #2 | #3 | #4 | #5 | | |
| a | 2.09 | 2.07 | 2.09 | 2.09 | 2.08 | | |
| b | 2.09 | 2.08 | 2.08 | 2.08 | 2.08 | | |
| c | 2.08 | 2.08 | 2.08 | 2.09 | 2.07 | Average | 2.08 |

(continued)

| A; specific heat capacity per unit volume J/(m$^3$·K) at each measurement position of Sample No. 4 Specific heat capacity per unit volume A is expressed by specific heat capacity Cp × bulk density ρ | | | | | | | |
|---|---|---|---|---|---|---|---|
| Table 8 | #1 | #2 | #3 | #4 | #5 | | |
| d | 2.08 | 2.08 | 2.08 | 2.09 | 2.09 | Standard deviation | 0.00513 |
| e | 2.07 | 2.07 | 2.08 | 2.08 | 2.08 | Coefficient of variation % | 0.25 |

[Table 9]

| λ; thermal conductivity W/(m·K) at each measurement position of Sample No. 4 | | | | | | | |
|---|---|---|---|---|---|---|---|
| Table 9 | #1 | #2 | #3 | #4 | #5 | max | 228 |
| a | 225 | 221 | 224 | 228 | 221 | min | 220 |
| b | 224 | 227 | 225 | 222 | 227 | max-min | 8 |
| c | 224 | 224 | 222 | 225 | 221 | Average | 224 |
| d | 223 | 220 | 226 | 222 | 222 | Standard deviation | 2.28 |
| e | 222 | 228 | 222 | 223 | 225 | Coefficient of variation % | 1.02 |

[Table 10]

| α; thermal diffusivity m$^2$/s at each measurement position of Sample No. 6 | | | | | | | |
|---|---|---|---|---|---|---|---|
| Table 10 | #1 | #2 | #3 | #4 | #5 | | |
| a | 107 | 102 | 106 | 108 | 101 | | |
| b | 102 | 107 | 102 | 106 | 102 | | |
| c | 102 | 107 | 105 | 101 | 106 | Average | 104 |
| d | 101 | 104 | 106 | 106 | 103 | Standard variation | 2.41 |
| e | 107 | 102 | 106 | 106 | 107 | Coefficient of variation % | 2.31 |

[Table 11]

| A; specific heat capacity per unit volume J/(m$^3$·K) at each measurement position of Sample No. 6 Specific heat capacity per unit volume A is expressed by specific heat capacity Cp × bulk density ρ | | | | | | | |
|---|---|---|---|---|---|---|---|
| Table 11 | #1 | #2 | #3 | #4 | #5 | | |
| a | 1.92 | 1.92 | 1.91 | 1.92 | 1.92 | | |
| b | 1.92 | 1.92 | 1.92 | 1.91 | 1.91 | | |
| c | 1.92 | 1.92 | 1.92 | 1.92 | 1.92 | Average | 1.92 |
| d | 1.91 | 1.91 | 1.92 | 1.92 | 1.92 | Standard variation | 0.00284 |
| e | 1.92 | 1.92 | 1.91 | 1.92 | 1.92 | Coefficient of variation % | 0.15 |

[Table 12]

| λ; thermal conductivity W/(m·K) at each measurement position of Sample No. 6 | | | | | | | |
|---|---|---|---|---|---|---|---|
| Table 12 | #1 | #2 | #3 | #4 | #5 | max | 206 |
| a | 205 | 195 | 203 | 206 | 194 | min | 193 |
| b | 195 | 204 | 195 | 203 | 195 | max-min | 13 |
| c | 195 | 204 | 202 | 194 | 204 | Average | 200 |
| d | 193 | 198 | 204 | 202 | 197 | Standard deviation | 4.58 |

(continued)

| λ; thermal conductivity W/(m·K) at each measurement position of Sample No. 6 | | | | | | | |
|---|---|---|---|---|---|---|---|
| Table 12 | #1 | #2 | #3 | #4 | #5 | max | 206 |
| e | 206 | 196 | 202 | 204 | 205 | Coefficient of variation % | 2.29 |

Thermal conductivity λ = thermal diffusivity α × specific heat capacity per unit volume A. Volumetric specific heat per unit volume A is expressed by specific heat capacity Cp × bulk density ρ.

It can be seen from these tables that scattering of thermal conductivity is caused by scattering of thermal diffusion. The tables show that the coefficient of variation of volumetric specific heat A obtained by multiplying density ρ by specific heat capacity Cp is sufficiently small compared to thermal diffusivity α, that is, scattering of density ρ and specific heat capacity Cp is small, that is, variations are small. Characteristic scattering of thermal conductivity λ in the present disclosure was suppressed by suppressing scattering of thermal diffusivity α.

It should be understood that the embodiments and examples disclosed herein are illustrative and non-restrictive in every respect. It is intended that the scope of the present invention is defined by claims, not by the above description, and encompasses all modifications and variations equivalent in meaning and scope to the claims.

REFERENCE SIGNS LIST

1 heat-dissipating substrate; 2 regions; 3 intersection point; 10 semiconductor device; 11 to 16 semiconductor element; 21 cooler; 31, 51 solder; 41 insulating substrate.

**Claims**

1.  A composite material comprising a heat-dissipating substrate of plate shape including a composite material including a metal and a silicon carbide, wherein

    a one-side surface of the heat-dissipating substrate is divided into a plurality of regions in a lattice, vertical and horizontal sides of each of the plurality of regions have a length of 10 mm or more and 25 mm or less, the plurality of regions in the lattice occupy 70% or more of an overall area of the one-side surface of the heat-dissipating substrate, and a thermal conductivity is 140 W/(m·K) or more at respective points of the plurality of regions in the lattice,
    a coefficient of variation of a thermal conductivity is less than 3.0% in the plurality of regions in the lattice, and the coefficient of variation is expressed as standard deviation/average value × 100 (%).

2.  The composite material according to claim 1, wherein the metal includes at least one selected from the group consisting of pure magnesium and a magnesium alloy.

3.  The composite material according to claim 1 or 2, wherein a content of the silicon carbide is 40% by volume or more and 95% by volume or less, a porosity is less than 3% by volume, and a remainder is a metal.

4.  The composite material according to claim 1 or 2, wherein a coefficient of thermal expansion at temperatures of 25°C to 150°C is 3.5 to 20 ppm/K.

5.  A heat-dissipating substrate comprising the composite material according to claim 1 or 2, wherein a coefficient of variation of a volumetric specific heat obtained by multiplying density by specific heat is smaller than the coefficient of variation of the thermal conductivity at respective points of the plurality of regions in the lattice.

6.  A semiconductor device comprising the composite material according to claim 1 or 2.

FIG.1

FIG.2

FIG.3

<table>
<tr><td colspan="2">INTERNATIONAL SEARCH REPORT</td><td colspan="2">International application No.<br>**PCT/JP2023/026041**</td></tr>
</table>

**A. CLASSIFICATION OF SUBJECT MATTER**

*H01L 23/373*(2006.01)i; *C04B 35/577*(2006.01)i; *C22C 29/06*(2006.01)i; *H01L 23/36*(2006.01)i
FI: H01L23/36 M; C22C29/06 Z; C04B35/577; H01L23/36 C

According to International Patent Classification (IPC) or to both national classification and IPC

**B. FIELDS SEARCHED**

Minimum documentation searched (classification system followed by classification symbols)

H01L23/373; C04B35/577; C22C29/06; H01L23/36

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 7050978 B1 (DENKA CO., LTD.) 08 April 2022 (2022-04-08)<br>paragraphs [0002], [0010]-[0051], [0078]-[0092], fig. 1, 2 | 1-2, 5-6 |
| Y | | 3-4 |
| Y | JP 2010-024077 A (DENKI KAGAKU KOGYO KK) 04 February 2010 (2010-02-04)<br>paragraphs [0035]-[0039] | 3-4 |
| A | JP 2005-076119 A (SUMITOMO ELECTRIC INDUSTRIES, LTD.) 24 March 2005<br>(2005-03-24)<br>entire text, all drawings | 1-6 |
| A | JP 2012-197496 A (SUMITOMO ELECTRIC INDUSTRIES, LTD.) 18 October 2012<br>(2012-10-18)<br>entire text, all drawings | 1-6 |

☐ Further documents are listed in the continuation of Box C.   ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **15 September 2023** | **26 September 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
**Information on patent family members**

International application No.

**PCT/JP2023/026041**

| Patent document cited in search report | | | Publication date (day/month/year) | Patent family member(s) | | | Publication date (day/month/year) |
|---|---|---|---|---|---|---|---|
| JP | 7050978 | B1 | 08 April 2022 | WO paragraphs [0002], [0010]-[0051], [0078]-[0092], fig. 1, 2 CN | 2022/181416 115867400 | A1 A | |
| JP | 2010-024077 | A | 04 February 2010 | (Family: none) | | | |
| JP | 2005-076119 | A | 24 March 2005 | (Family: none) | | | |
| JP | 2012-197496 | A | 18 October 2012 | US entire text, all drawings WO EP CN | 2013/0328184 2012/127958 2690186 103443315 | A1 A1 A1 A | |

Form PCT/ISA/210 (patent family annex) (January 2015)

## REFERENCES CITED IN THE DESCRIPTION

### Patent documents cited in the description

- JP 2022133332 A
- JP 2006299304 A
- JP 2010090436 A
- JP 2010106362 A
- WO 2018105297 A
- JP 2011073055 A
- JP 2016007634 A
- JP 2011073950 A

### Non-patent literature cited in the description

- Netsudendouritu, netsukakusanritsu no hyoujun nit-suite. Megumi Akoshima from National Institute of Advanced Industrial Science and Technology, "Nestudendouritu, netsukakusanritu no seigyo to sokuteihyoukahouhou [Control, and Measurement and Evaluation Methods for Thermal Conductivity and Thermal Diffusivity. Science & Technology Co., Ltd